(19) **Europäisches Patentamt**

**European Patent Office**

**Office européen des brevets**

(11) Veröffentlichungsnummer: **0 218 921 B1**

(12) **EUROPÄISCHE PATENTSCHRIFT**

(45) Veröffentlichungstag der Patentschrift: **15.12.93**

(21) Anmeldenummer: **86112548.2**

(22) Anmeldetag: **10.09.86**

(51) Int. Cl.5: **H01J 49/44**, H01J 37/00, H01J 37/05

(54) **Elektronenenergiefilter vom Alpha-Typ.**

(30) Priorität: **13.09.85 DE 3532698**

(43) Veröffentlichungstag der Anmeldung:
**22.04.87 Patentblatt 87/17**

(45) Bekanntmachung des Hinweises auf die
Patenterteilung:
**15.12.93 Patentblatt 93/50**

(84) Benannte Vertragsstaaten:
**DE NL**

(56) Entgegenhaltungen:
**DE-A- 2 031 811**
**DE-B- 1 195 517**
**GB-A- 2 098 797**
**US-A- 4 412 131**

(73) Patentinhaber: **Firma Carl Zeiss**

**D-73446 Oberkochen(DE)**

(72) Erfinder: **Rose, Harald, Prof. Dr.**
**Prinz-Christians-Weg 5 1/2**
**D-6100 Darmstadt(DE)**
Erfinder: **Lanio, Stefan**
**Eichendorffstrasse 20**
**D-6101 Rossdorf 2(DE)**

## Beschreibung

Die vorliegende Erfindung betrifft ein abbildendes magnetisches Elektronenenergiefilter vom Alpha-Typ, vorzugsweise für Elektronenmikroskope, mit Umlenkbereichen in Magnetfeldern, von denen ein Umlenkbereich beim Eintritt in das Energiefilter und beim Austritt aus dem Energiefilter durchlaufen wird.

Abbildende Elektronenenergiefilter, auch Elektronenfilter, Energiefilter oder Elektronen(energie)-spektrometer genannt, werden bei Transmissions-Elektronenmikroskopen verwendet, um den Kontrast der Objektabbildung durch die Auswahl von Elektronen eines bestimmten Energiebereiches zu verbessern. Das ist am deutlichsten erkennbar bei nicht kontrastierten, sehr dünnen Präparaten mit einem gewählten Energieverlust ($\Delta E$) im Bereich von ca. 100 bis 200 eV. Aber auch ein Objektbild, das durch rein elastisch gestreute Elektronen (Energieverluste $\Delta E = 0$) entsteht, indem alle unelastisch gestreuten Elektronen ($\Delta E > 0$) ausgeblendet werden, ist im Kontrast gegenüber dem ungefilterten Bild deutlich verbessert.

Ein weiterer wesentlicher Vorteil eines Transmissions-Elektronenmikroskopes mit einem abbildenden Elektronenfilter besteht in der Möglichkeit element-spezifische Objektabbildungen, d.h. Element-Verteilungsbilder, gleichzeitig von einem relativ großen Objektbereich dadurch durchzuführen, daß der vom Elektronenfilter durchgelassene Energiebereich einer element-spezifischen Wechselwirkung der transmittierten Elektronen mit dem Objekt entspricht, also z.B. einer K-, L-, M-Absorption in der Atomhülle. Damit können qualitative und bei Messung der Intensitätsverhältnisse und Abzug des Untergrundes auch quantitative Verteilungsbilder von Elementen in dünnen Objekten ($\leq 30$ nm) mit sehr hoher Ortsauflösung ($\approx 0,5$ nm) und höchster Nachweisempfindlichkeit ($\approx 2.10^{-21}$ g) gewonnen werden, die bisher mit keiner anderen Analysentechnik erreicht wurden. Höchste Ortsauflösung und Nachweisempfindlichkeit von Elementen sind sowohl für die biologische und medizinische Forschung als auch für die Material-Wissenschaft von großer Bedeutung.

Auch bei Elektronenbeugungsdiagrammen bewirkt ein abbildendes Elektronenfilter durch die Ausblendung von unelastisch gestreuten Elektronen schärfere Bilder des Beugungsdiagrammes. Außerdem können Beugungsdiagramme von unelastisch gestreuten Elektronen eines bestimmten Energiebereiches aufgenommen werden.

Aus der DE-A-20 28 357 ist ein Elektronenmikroskop bekannt, das eine Filterung des Objektbildes oder des Beugungsdiagrammbildes ermöglicht. Dabei wird ein Elektronenfilter vom sog. Castaing-Typ verwendet, das aus einem magnetischen Prisma und einem elektrostatischen Spiegel besteht. Letzterer ist jedoch sehr empfindlich gegenüber äußeren Störfeldern; außerdem treten bei hohen Beschleunigungsspannungen für die Elektronen Isolationsprobleme auf. Daher werden in neuerer Zeit rein magnetische Filter bevorzugt, die für beliebig hohe Beschleunigungsspannungen geeignet sind. Bei diesen Energiefiltern unterscheidet man nach dem Verlauf der Elektronenbahnen sog. Alpha- und Omega-Filter.

Ein Alpha-Filter ist aus einer Veröffentlichung von J. Ph. Perez e.a. (Journal de Physique, Colloque C2, supplement au n 2, 45, C2-171 (1984)) bekannt. Es besteht aus zwei magnetischen Sektoren (Umlenkbereichen) mit unterschiedlichen Feldstärken, welche durch einen schmalen Zwischenraum getrennt sind, wobei einer der Sektoren beim Eintritt in das Filter und beim Austritt aus dem Filter durchlaufen wird.

Ein abbildendes Elektronenfilter muß, damit es in einem Elektronenmikroskop optimal verwendet werden kann, folgende zwei Bedingungen erfüllen: Eine große Anzahl von Bildpunkten muß ohne Verlust an Ortsauflösung übertragen werden und die Bildfehler in der Ausgangsquellebene (auch als Selektionsebene bezeichnet) müssen so gering sein, daß kleine Energiebreiten (der durchgelassenen Elektronen) realisiert werden können. Die letztere Bedingung wird von dem bekannten Alpha-Filter nicht erfüllt; die kleinste Energiebreite beträgt ca. 700 eV.

Der vorliegenden Erfindung liegt daher die Aufgabe zugrunde, ein Alpha-Filter anzugeben, das nicht nur eine gute Ortsauflösung hat, sondern auch kleine Energiebreiten ermöglicht.

Die gestellte Aufgabe wird erfindungsgemäß durch ein Filter mit den Merkmalen des Anspruchs 1 gelöst. Es hat drei Umlenkbereiche, welche durch Zwischenräume getrennt sind. Die Umlenkwinkel und die Winkel zwischen den Polschuhkanten und den Wellenfronten des Elektronenstrahles liegen in den angegebenen Wertebereichen.

In einer besonders vorteilhaften Ausführungsform werden die Randfelder, welche außerhalb der Kanten der Polschuhe entstehen, durch Abschirmplatten (in der Literatur teilweise auch als mirror plates oder field clamps bezeichnet) wesentlich verkleinert. Diese Abschirmplatten sind mindestens an den Stellen, wo der Elektronenstrahl in die Umlenkbereiche ein- und austritt, in einem geringen Abstand von den Polschuhkanten und vorzugsweise in gleicher Höhe wie die Polschuhoberflächen angeordnet. In einer weiteren vorteilhaften Ausführungsform bilden die Abschirmplatten mit den Polschuhen ein gemeinsames Teil z.B. aus Weicheisen, wobei die Spulen zur Erzeugung des Magnetfeldes in einen in sich geschlossenen Kanal eingelegt sind, der die Polschuhoberflächen von den umgebenden Abschirmflächen trennt. Diese Technik zur Herstellung von homogenen Magnetfeldern mit kleinen und definierten Randfeldern ist aus einer Arbeit von A.V. Crewe e.a. (Rev. Sci. Instr. 42, 411 (1971) bekannt.

In der Mittelebene des erfindungsgemäßen Energiefilters liegt ein astigmatisches Zwischenbild der Eingangsbildebene mit einem Strichfokus parallel zur Ablenkfeldrichtung und ein astigmatisches Zwischenbild der Eingangsquellebene mit einem Strichfokus senkrecht zur Ablenkfeldrichtung. Außerdem erfolgt eine achromatische und stigmatisches Abbildung der Eingangsbildebene in die Ausgangsbildebene im Maßstab 1:1, sowie eine dispersive und stigmatische Abbildung der Eingangsquellebene in die Ausgangsquellebene.

Ein wesentlicher Vorteil des Energiefilters mit Abschirmplatten besteht darin, daß es leicht zu justieren ist und daß Störfelder gut abgeschirmt werden.

Die Erfindung wird im folgenden anhand von in den Figuren 1 bis 2b dargestellten Ausführungsbeispielen näher erläutert. Dabei zeigen

Fig. 1      den Aufbau eines Alpha-Filters;
Fig. 2a      einen Schnitt durch ein Ablenksystem aus zwei Polschuhen mit integrierten Abschirmplatten und
Fig. 2b      eine Draufsicht auf einen Polschuh mit integrierten Abschirmplatten.

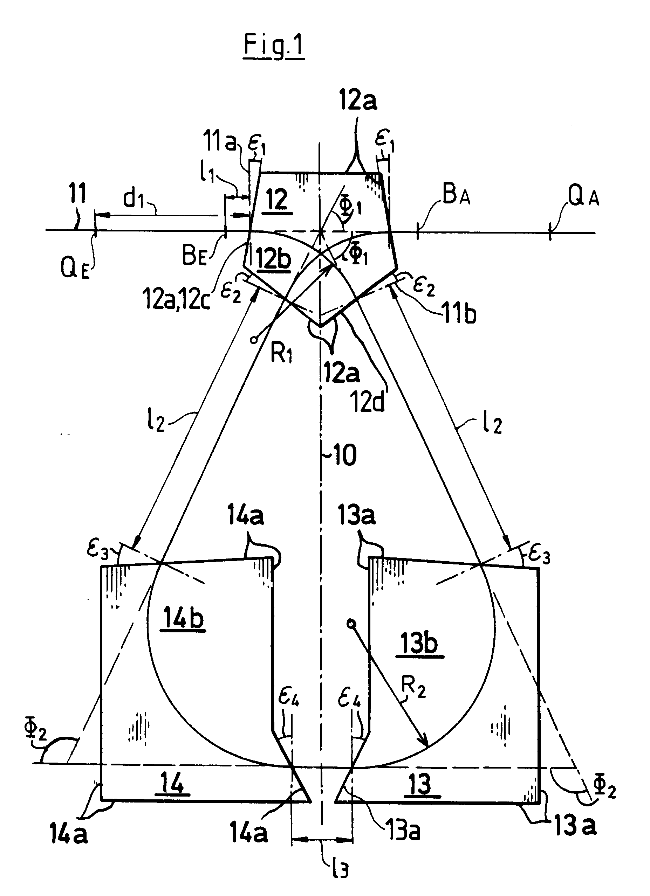

In Fig. 1 ist die Zeichenebene diejenige Ebene, in welcher die Mittelachse (11) des Elektronenstrahls durch das Filter läuft. Auch das erfindungsgemäße Alpha-Filter ist symmetrisch zur Mittelebene aufgebaut, welche senkrecht auf der Zeichenebene steht und diese in der Linie (10) schneidet.

Das in der Figur 1 dargestellte Filter besteht aus Magneten, von denen die unter der Zeichenebene liegenden Polschuhe (12, 13 und 14) mit ihren Kanten (12a, 13a und 14a) dargestellt sind. Zwischen den unter- und oberhalb zur Zeichenebene liegenden Polschuhen, welche spiegelbildlich gleich zur Zeichenebene ausgebildet sind, bestehen homogene Magnetfelder, welche den Elektronenstrahl in den Umlenkbereichen (12b, 13b und 14b) auf Kreisbahnen mit ersten und zweiten Umlenkradien ($R_1$) und ($R_2$) um erste und zweite Umlenkwinkel ($\phi_1$) und ($\phi_2$) ablenken, wobei die exakten Radien und Winkel von der Energie der Elektronen abhängen, wodurch in der Ausgangsquellebene ($Q_A$) ein Energiespektrum entsteht, von dem Bereiche ausgeblendet werden können.

Beim Eintritt des Elektronenstrahls (11) in den ersten Umlenkbereich (12b) bildet die Eintrittskante (12c) des Polschuhs (12) (und entsprechend die nicht gezeichnete Eintrittskante des zur Zeichenebene spiegelbildlich angeordneten zweiten Polschuhes für das Magnetfeld) mit der Richtung (11a) der Wellenfront des Elektronenstrahles (11) den

Winkel ($\epsilon_1$). Zwischen der Richtung (11b) der Wellenfront des aus dem Umlenkbereich (12b) austretenden Elektronenstrahles (11) und der Austrittskante (12d) des Polschuhes (12) besteht der Winkel ($\epsilon_2$). Entsprechende Ein- und Austrittswinkel ($\epsilon_3$) und ($\epsilon_4$) gelten beim Ein- und Austritt in den zweiten Umlenkbereich(13b). Zwischen den Umlenkbereichen (12b, 13b, 14b) bestehen verhältnismäßig große Abstände ($l_2$ und $l_3$).

Infolge des symmetrischen Aufbau des Filters gelten für den Ein- und Austritt aus den Umlenkbereichen (14b) und (12b) beim zweiten Durchgang ebenfalls die Ein- und Austrittswinkel ($\epsilon_1$, $\epsilon_2$, $\epsilon_3$, $\epsilon_4$), wie in der Figur 1 angegeben. Durch geeignete Wahl dieser zwischen den Wellenfronten und Polschuhkanten bestehenden Winkel läßt sich eine Fokussierung des Elektronenstrahles auch in der zur Zeichenebene senkrechten Ebene erreichen. Für eine gute Korrektur der Abbildungsfehler haben sich folgende Bereiche als vorteilhaft herausgestellt

$$50° \leq \phi_1 \leq 75°$$
$$105° \leq \phi_2 \leq 130°$$
$$-5° \leq \epsilon_1 \leq 15°$$
$$-5° \leq \epsilon_2 \leq 20°$$
$$20° \leq \epsilon_3 \leq 40°$$
$$-35° \leq \epsilon_4 \leq -15°$$
$$0,8 \leq R_2/R_1 \leq 1,6$$

Die weiteren geometrischen Abmessungen des Energiefilters ($d_1$, $l_1$, $l_2$, $l_3$ und $R_2/R_1$) ergeben sich dann zwangsläufig aus der Forderung einer mindestens annähernd stigmatischen Abbildung der Eingangsbildebene ($B_E$) in die Ausgangsbildebene ($B_A$) und der Eingangsquellebene ($Q_E$) in die Ausgangsquellebene ($Q_A$).

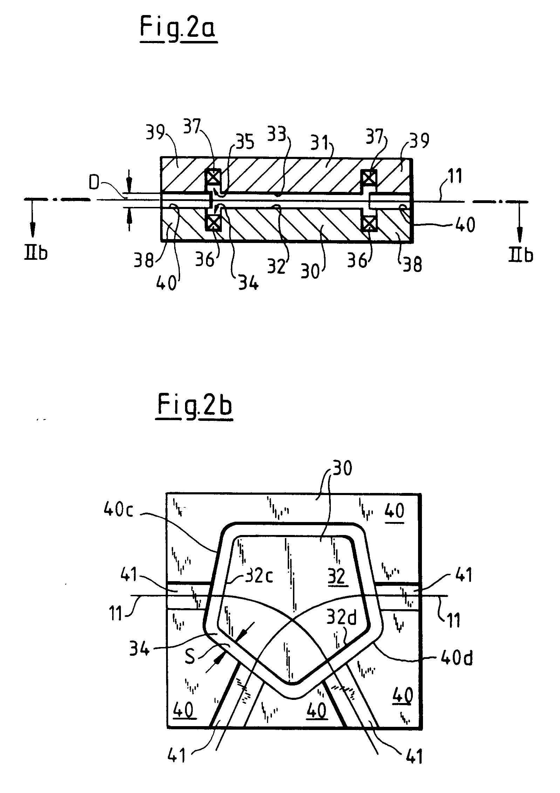

Die in der Figur 1 dargestellten Polschuhe (12, 13 und 14) haben sehr ausgedehnte Randfelder, welche den Elektronenstrahl (11) auch außerhalb der Umlenkbereiche (12b, 13b und 14b) beeinflussen. Diese Randfelder lassen sich durch Abschirmplatten wesentlich verkleinern. In den Figuren 2a und 2b ist eine besonders vorteilhafte Ausführungsform hierfür dargestellt, bei welcher der in Figur 1 mit (12) bezeichnete Polschuh ein gemeinsames Teil (30) mit den Abschirmplatten bildet. Das Teil (30) kann ebenso wie das zum Ablenksystem gehörende zweite Teil (31) z.B. aus Weicheisen sein. In die Teile (30) und (31) sind Nuten (34) und (35) mit der Breite (S) eingearbeitet, deren innere Kontur die Form der Polschuhe (32) und (33) z.B. mit den Kanten (32c) und (32d) bildet. Die äußere Kontur der Nuten (34) und (35) bildet z.B. die Kanten (40c) und (40d) der Abschirmplatte (38). Ein durch die in den Nuten (34) und (35) liegenden Spulen (36) und (37) fließender Strom erzeugt zwischen den Polschuhen (32) und (33) ein homogenes magnetisches Feld. Außerhalb der Nuten (34) und (35) entsteht dagegen kein magnetisches Feld, so daß das Randfeld im wesentlichen auf die Breite (S) der Nuten beschränkt ist. Zweckmäßigerweise ist der Abstand (D) der Abschirmplatten (38) und (39) an den Stellen (41), wo der Elektronenstrahl (11) durchläuft ebenso groß wie der Abstand der Polschuhoberflächen (32) und (33). Das muß jedoch nicht der Fall sein. An den übrigen Stellen (40) liegen die Abschirmplatten (38) und (39) unmittelbar aufeinander.

Die größte Anzahl von Bildpunkten, die ohne Verlust an Ortsauflösung übertragen werden, und die geringsten Fehler in der Ausgangsquellebene ($Q_A$), so daß möglichst kleine Energiebreiten erreichbar sind, werden durch die im Anspruch 3 angegebenen Werte erreicht. Dabei sind die geometrischen Abmessungen des Filters so normiert, daß durch geeignete Wahl von $R_1$ die Differenz der Abstände $d_1 - l_1$ dem Abstand zwischen Quellebene und Bildebene angepaßt werden kann, der vom Abbildungssystem eines beliebigen Elektronmikroskops vorgegeben ist.

Im Vergleich zu dem im Stand der Technik erwähnten Energiefilter hat ein Filter mit den im Anspruch 3 angegebenen Werten eine um weniger als den Faktor 2 schlechteren Ortsauflösung, dafür aber eine um mehr als den Faktor 200 bessere Energieauflösung. Bei gängigen Elektronenmikroskopen mit einem Endbildradius von 50 mm sind damit Energiebreiten $\Delta E$ bis zu 2,6 eV möglich.

**Patentansprüche**

1. Abbildendes magnetisches Elektronenenergiefilter vom Alpha-Typ, vorzugsweise für Elektronenmikroskope, mit Umlenkbereichen in Magnetfeldern, von denen ein Umlenkbereich beim Eintritt in das Energiefilter und beim Austritt aus dem Energiefilter durchlaufen wird, dadurch gekennzeichnet, daß drei Umlenkbereiche (12b, 13b, 14b) vorgesehen sind, welche durch Abstände ($l_2$, $l_3$) getrennt sind, daß in den Umlenkbereichen (12b, 13b, 14b) erste und zweite Umlenkwinkel ($\phi_1$, $\phi_2$) in den Wertebereichen

   $50° \leq \phi_1 \leq 75°$
   $105° \leq \phi_2 \leq 130°$

   und ein Verhältnis der Umlenkradien ($R_1$, $R_2$) in dem Wertebereich

   $0,8 \leq R_2/R_1 \leq 1,6$

   liegen, daß beim Eintritt des Elektronenstrahls (11) in den ersten Umlenkbereich (12b) die Eintrittskante (12c) des ersten Polschuhs (12) einen Winkel $\epsilon_1$, beim Austritt des Elektronenstrahls aus dem ersten Umlenkbereich die Austrittskante (12d) des ersten Polschuhs (12) einen Winkel $\epsilon_2$, beim Eintritt des Elektronenstrahls in den zweiten Umlenkbereich die Eintrittskante des zweiten Polschuhs (13) einen Winkel $\epsilon_3$ und beim Austritt aus dem zweiten Umlenkbereich (13b) die Austrittskante (13a) des zweiten Polschuhs (13) einen Winkel $\epsilon_4$ mit der jeweils zugehörigen Richtung (11a, 11b) der Wellenfront des Elektronenstrahls bilden, wobei die Ein- und Austrittswinkel ($\epsilon_1$, $\epsilon_2$, $\epsilon_3$, $\epsilon_4$) innerhalb der Wertebereiche

   $-5° \leq \epsilon_1 \leq 15°$
   $-5° \leq \epsilon_2 \leq 20°$
   $20° \leq \epsilon_3 \leq 40°$
   $-35° \leq \epsilon_4 \leq -15°$

   liegen und daß die geometrischen Abmessungen ($d_1$, $l_1$, $l_2$, $l_3$, $R_2/R_1$) so gewählt sind, daß in einer Ausgangsbildebene ($B_A$) eine mindestens annähernd stigmatische Abbildung einer Eingangsbildebene ($B_E$) und in einer Ausgangsquellebene ($Q_A$) eine mindestens annähernd stigmatische Abbildung einer Eingangsquellebene ($Q_E$) erfüllt ist.

2. Energiefilter nach Anspruch 1, dadurch gekennzeichnet, daß vor dem ersten Umlenkbereich (12b), zwischen den Umlenkbereichen (12b, 13b, 14b, 12b) und nach dem letzten Umlenkbereich (12b) Abschirmplatten (38, 39) angeordnet sind, deren Oberflächen mindestens annähernd in der Höhe der Oberflächen der Polschuhe (32, 33) liegen und deren Kanten (40c, 40d) im geringen Abstand (S) parallel zu den Kanten (32c, 32d) der Polschuhe angeordnet sind.

3. Energiefilter nach Anspruch 2, gekennzeichnet durch folgende Werte für die Umlenkwinkel ($\phi_1$, $\phi_2$), die Ein- und Austrittswinkel ($\epsilon_1$, $\epsilon_2$, $\epsilon_3$, $\epsilon_4$) und das Verhältnis der Umlenkradien ($R_1/R_2$)

   $\phi_1 = 65°$
   $\phi_2 = 115$
   $\epsilon_1 = 9,5°$
   $\epsilon_2 = 13,7°$
   $\epsilon_3 = 29,4°$
   $\epsilon_4 = -27,5°$
   $R_2/R_1 = 1,2$

   und durch folgende geometrische Abmessungen

   $d_1 = 1,73 R_1$
   $l_1 = 0,28 R_1$

$l_2 = 2{,}41 \; R_1$
$l_3 = 0{,}50 \; R_1$
$S = 0{,}10 \; R_1$
$D = 0{,}10 \; R_1$

wobei ($l_1$) den Abstand der Eingangsquellebene von der Eintrittskante des Filters, ($l_2$) den Abstand zwischen dem ersten und zweiten Umlenkbereich, ($l_3$) den Abstand zwischen dem zweiten und dritten Umlenkbereich, ($S$) den Abstand zwischen den Abschirmplatten (38, 39) und den Kanten der Polschuhe, und ($D$) den Abstand der Abschirmplatten (38, 39) im Bereich des Elektronenstrahls beschreibt und wobei ($R_1$) so gewählt ist, daß die Differenz ($d_1 - l_1$) gleich dem vom Abbildungssystem des Elektronenmikroskops vorgegebenen Abstand zwischen Quellebene und Bildebene ist.

4. Energiefilter nach einem der Ansprüche 1 bis 3, dadurch gekennzeichnet, daß in einer Mittelebene (10) ein astigmatisches Zwischenbild der Eingangsbildebene ($B_E$) mit einem Strichfokus parallel zur Ablenkfeldrichtung und ein astigmatisches Zwischenbild der Eingangsquellebene ($Q_E$) mit einem Strichfokus senkrecht zur Ablenkfeldrichtung liegt.

**Claims**

1. An imaging magnetic electron-energy filter of the alpha type, preferably for an electron microscope, having deflecting regions within magnetic fields, whereby one of the deflecting regions is passed at the entrance into the energy filter and at the exit of the energy filter, characterized by the fact, that three deflecting regions (12b, 13b, 14b) which are separated by interspaces ($l_2$, $l_3$) are provided, that within the deflecting regions (12b, 13b, 14b) first and second deflection angles ($\Phi_1$, $\Phi_2$) are lying in the respective value range of

$$50° \leq \Phi_1 \leq 75°$$
$$105° \leq \Phi_2 \leq 130°$$

and a ratio of the deflection radii lying in the value range

$$0{,}8 \leq R2 / R_1 \leq 1{,}6,$$

that at the entrance of the electron beam (11) into the first deflecting region (12) the entry edge of the first pole shoe (12) forms an angle $\epsilon_1$, at the exit of the electron beam of the first deflecting region the exit edge (12d) of the first pole shoe (12) forms an angle $\epsilon_2$, at the entrance of the electron beam into the second deflecting region the entry edge of the second pole shoe forms an angle $\epsilon_3$ and at the exit of the second deflecting region (13b) the exit edge (13a) of the second pole shoe (13) forms an angle $\epsilon_4$ with respect to the respective appertaining wave front direction (11a, 11b) of the electron beam, whereby the entrance angles and the exit angles are lying within the respective value range of

$$-5° \leq \epsilon_1 \leq 15°$$
$$-5° \leq \epsilon_2 \leq 20°$$
$$20° \leq \epsilon_3 \leq 40°$$
$$-35° \leq \epsilon_4 \leq -15°$$

and that the geometric dimensions ($d_1$, $l_1$, $l_2$, $l_3$, $R_2/R_1$) are selected so as to cause at least an approximate stigmatic imaging of an entry image plane ($B_E$) into an exit image plane ($B_A$) and so as to cause at least an approximate stigmatic imaging of an entry source plane ($Q_E$) into an exit source plane ($Q_A$).

2. Energy-Filter according to claim 1, characterized by the fact, that shielding plates (38, 39), having surfaces at least approximately at the elevation of the surfaces of the pole shoes (32, 33) and having edges (40c, 40d) at narrow spacing (S) parallel to the edges (32c, 32d) of the pole shoes, are provided ahead of the first deflecting region (12b), between the deflecting regions (12b, 13b, 14b,12b) and behind the last deflecting region (12b).

3. Energy-filter according to claim 2, characterized by the following values of the deflection angles ($\Phi_1$, $\Phi_2$), the entrance and exit angles ($\epsilon_1$, $\epsilon_2$, $\epsilon_3$, $\epsilon_4$) and the ratio of the deflection radii ($R_1/R_2$)

$$\Phi_1 = 65°$$
$$\Phi_2 = 115°$$
$$\epsilon_1 = 9.5°$$
$$\epsilon_2 = 13.7°$$
$$\epsilon_3 = 29.4°$$
$$\epsilon_4 = -27.5°$$
$$R_2/R_1 = 1.2$$

and the following geometric dimensions

$$d_1 = 1.73 \; R_1$$
$$l_1 = 0.28 \; R_1$$
$$l_2 = 2.41 \; R_1$$
$$l_3 = 0.50 \; R_1$$
$$S = 0.10 \; R_1$$
$$D = 0.10 \; R_1$$

whereby ($l_1$) defines the distance between the entry source plane and the entrance edge of the filter, ($l_2$) defines the distance between the first and second deflecting region, ($l_3$) defines the distance between the second and third deflecting region, (S) defines the distance between the shielding plates (38, 39) and the edges of the pole shoes and (D) defines the spacing of the shielding plates within the region of the electron beam and whereby ($R_1$) is selected so that the difference ($d_1 - l_1$) is equal to the distance between the source plane and the image plane as required by the imaging system of the electron microscope.

4. Energy-filter according to one of the claims 1 to 3, characterized by the fact, that an astigmatic intermediate image of the entry image plane ($B_E$) having a line focus parallel to the deflecting direction and that an astigmatic intermediate image of the entry source plane ($Q_E$) having a line focus perpendicular to the deflecting direction are generated in a center plane.

**Revendications**

1. Filtre magnétique de type alpha, d'énergie d'électrons, générateur d'image, destiné de préférence à des microscopes électroniques, avec des zones de déviation dans des champs magnétiques, dont l'une de ces zones de déviation est parcourue tant à l'entrée dans le filtre d'énergie qu'à la sortie dudit filtre d'énergie, caractérisé en ce que trois zones de déviation (12b, 13b, 14b) sont prévues, séparées par les écarts ($l_2$, $l_3$), et en ce que dans les zones de déviation (12b, 13b, 14b) le premier et le second angle de déviation ($\phi_1$, $\phi_2$) se situent dans les plages de valeurs

$50° \leq \phi_1 \leq 75°$
$105° \leq \phi_2 \leq 130°$

et le rapport des rayons de déviation ($R_1$, $R_2$) se trouve dans la plage de valeurs

$0,8 \leq R_2/R_1 \leq 1,6,$

en ce que à l'entrée du faisceau d'électrons (11) dans la première zone de déviation (12b) l'arête d'incidence (12c) de la première pièce polaire (12) forme un angle $\epsilon 1$, à la sortie du faisceau d'électrons de la première zone de déviation l'arête d'émergence (12d) de la première pièce polaire (12) décrit un angle $\epsilon 2$, à l'entrée du faisceau d'électrons dans la deuxième zone de déviation l'arête d'incidence de la seconde pièce polaire (13) forme un angle $\epsilon 3$, à la sortie du faisceau d'électrons de la deuxième zone de déviation (13b) l'arête d'émergence (13a) de la seconde pièce polaire (13) décrit un angle $\epsilon 4$ par rapport à la direction (11a, 11b) suivie respectivement par le front d'onde du faisceau d'électrons les angles d'incidence et d'émergence ($\epsilon 1$, $\epsilon 2$, $\epsilon 3$, $\epsilon 4$) étant alors compris dans les plages de valeurs

$-5° \leq \epsilon 1 \leq 15°$
$-5° \leq \epsilon 2 \leq 20°$
$20° \leq \epsilon 3 \leq 40°$
$-35° \leq \epsilon 4 \leq -15°$

et en ce que les dimensions géométriques ($d_1$, $l_1$, $l_2$, $l_3$, $R_2/R_1$) sont choisies de façon à ce que l'image reproduite d'un plan de l'image d'entrée ($B_E$) soit au moins pratiquement stigmatique dans un plan d'image de sortie ($B_A$) de même que l'image reproduite d'un plan de la source d'entrée ($Q_E$) dans un plan de la source de sortie ($Q_A$)

2. Filtre d'énergie défini selon la revendication 1, caractérisé en ce que des plaques de protection (38, 39) sont disposées devant la première zone de déviation (12b) entre les zones de déviation (12b, 13b, 14b, 12b) et derrière la dernière zone de déviation (12b), en ce que les surfaces de ces plaques se trouvent quasiment au moins à la hauteur des surfaces des pièces polaires (32, 33) et leurs arêtes (40c, 40d) à la faible distance (S) parallèle aux arêtes (32c, 32d) des pièces polaires.

3. Filtre d'énergie défini selon la revendication 2, caractérisé par les valeurs suivantes relatives aux angles de déviation ($\phi_1$, $\phi_2$) aux angles d'incidence et d'émergence ($\epsilon 1$, $\epsilon 2$, $\epsilon 3$, $\epsilon 4$), ainsi qu'au rapport des rayons de déviation ($R_1/R_2$)

$\phi_1 = 65°$
$\phi_2 = 115°$
$\epsilon 1 = 9,5°$
$\epsilon 2 = 13,7°$
$\epsilon 3 = 29,4°$
$\epsilon 4 = -27,5°$
$R_2/R_1 = 1,2$

par les dimensions géométriques suivantes

$d_1 = 1,73 R_1$
$l_1 = 0,28 R_1$
$l_2 = 2,41 R_1$
$l_3 = 0,50 R_1$
$S = 0,10 R_1$

D = 0,10 R$_1$

où (l$_1$) décrit l'écart compris entre le plan de la source d'entrée et l'arête d'entrée du filtre, (l$_2$) l'écart compris entre la première zone de déviation et la deuxième, (l$_3$) l'écart compris entre la deuxième zone de déviation et la troisième, (S2) l'écart compris entre les plaques de protection (38, 39) et les arêtes des pièces polaires et (D) l'écart des plaques de protection (38, 39) dans la zone du faisceau d'électrons, et où (R$_1$) est déterminé de manière à ce que la différence (d$_1$ - l$_1$ ) soit égale à la distance qui sépare le plan de l'image du plan de la source et qui est prédéterminée par le système de formation de l'image du microscope électronique.

4. Filtre d'énergie défini selon les revendications énoncées de 1 à 3, caractérisé en ce que dans un plan médian (10) une image intermédiaire astigmatique du plan de l'image d entrée (B$_E$) se forme sous forme d'une ligne focale parallèle à la direction du champ de déviation et une image intermédiaire astigmatique du plan de la source d entrée (Q$_E$) sous forme d'une ligne focale perpendiculaire à la direction du champ de déviation.

Fig.1

## Fig.2a

## Fig.2b